# EUROPÄISCHE PATENTSCHRIFT

(11) **EP 2 647 126 B1**
(45) Veröffentlichungstag und Bekanntmachung des Hinweises auf die Patenterteilung: **16.04.2014**
(21) Anmeldenummer: 11790952.3
(22) Anmeldetag: 29.11.2011
(51) Int. Cl.: H03K 17/96, H03K 17/965

(54) **BEDIENEINHEIT MIT KAPAZITIVEM BERÜHRUNGSSENSOR**
ACTIVATOR WITH CAPACITIVE TOUCH SENSOR
UNITÉ DE COMMANDE, EN PARTICULIER POUR UN COMPOSANT DE VÉHICULE

(30) Priorität: 03.12.2010 DE 102010053342
(43) Veröffentlichungstag der Anmeldung: 09.10.2013
(73) Patentinhaber: Behr-Hella Thermocontrol GmbH, 70469 Stuttgart (DE)
(72) Erfinder: FUST, Winfried, 59556 Lippstadt (DE); VOGT, Frank, 33165 Lichtenau (DE)
(74) Vertreter: von Kreisler Selting Werner
(86) Internationale Anmeldenummer: PCT/EP2011/071235
(87) Internationale Veröffentlichungsnummer: WO 2012/072608

(56) Entgegenhaltungen:
- EP-A1- 1 635 366
- DE-C1- 3 109 911

## Beschreibung

Die Erfindung betrifft eine Bedieneinheit für insbesondere eine Fahrzeugkomponente wie z. B. ein Radio, ein Navigationsgerät, ein Klimasteuergerät oder ein Infotainment-System.

Zur Verbesserung des Bedienkomforts von z. B. Fahrzeugkomponenten-Bedienelementen ist es bekannt, manuell betätigbare Bedienelemente mit einer Annäherungssensorik auszustatten, mit der eine Annäherung an das und eine Berührung des Bedienelements mit z. B. den Fingern einer Hand erkannt werden kann. Dies kann z. B. dazu genutzt werden, vor der Aktivierung des eigentlichen Bedienbefehls oder der Auswahl eines Menüunterpunktes auf einer graphischen Bedienefoberfläche der die Bedieneinheit betätigenden Person zuvor nicht dargestellte Informationen anzuzeigen.

Beispiele derartiger auch unter dem Begriff der kapazitiven Vorfelderkennung bekannter Konzepte für die konstruktive Ausführung einer kapazitiven Annäherungssensorik sind in DE-A-10 2005 029 503, DE-A-10 2005 029 512, DE-A-10 2006 054 764 und WO-A-2007/014780 beschrieben. Ein Joystick-Schalthebel mit kapazitiver Sensorik zur Erfassung ausschließlich der Bewegung des Schalthebels ist in DE-B-29 31 489 beschrieben.

Die bekannten Bedieneinheiten der vorstehend genannten Art weisen zumindest ein manuell betätigbares Bedienelement zum Auswählen und gegebenenfalls zusätzlich auch zum Aktivieren einer Bedienfunktion auf. Ferner ist ein kapazitiver Berührungssensor vorgesehen, der eine erste und eine zweite Elektrode aufweist und mit einer Auswerteschaltung (bzw. allgemein Auswerteeinheit) verbunden ist, über die durch eine Kapazitätsänderung die Annäherung einer Hand an das Bedienelement und/oder die Berührung des Bedienelements durch die Hand erkannt wird. Dabei müssen die auf eine Berührung/Annäherung zurückzuführenden Kapazitätsänderungssignale des Berührungssensors von Rausch- oder anderen Störsignalen unterschieden werden. Während der Berührung des Bedienelements verursacht dessen Betätigung und insbesondere Bewegung durch z. B. Drehen eines Bedienknopfes, Verschieben eines Schiebeknopfes und Niederdrücken der Knöpfe bzw. von Druck- bzw. Kipp-(Wipp-)Tasten Kapazitätsänderungen in dem Berührungssensor, die ohne zum Teil aufwändige schaltungstechnische Gegenmaßnahmen von der Auswerteeinheit fehlinterpretiert werden können.

Aufgabe der Erfindung ist es, die Detektion der Berührung eines Bedienelements einer mit einer kapazitiven Annäherungssensorik versehenen Bedieneinheit zu verbessern.

Zur Lösung dieser Aufgabe wird mit der Erfindung eine Bedieneinheit, insbesondere für eine Fahrzeugkomponente, vorgeschlagen, die versehen ist mit
- einem manuell betätigbaren Bedienelement zum Auswählen und optional zum Aktivieren einer Bedienfunktion,
- wobei das Bedienelement manuell in eine Auswähl- und/oder Auslöseposition zum Auswählen und optional zum Aktivieren einer Bedienfunktion überführbar ist, und
- einem kapazitiven Berührungssensor zur Erkennung einer manuellen Berührung des Bedienelements und optional einer Annäherung an das Bedienelement durch eine Hand,
- wobei der Berührungssensor eine erste und eine zweite Elektrode aufweist, die im Wesentlichen einander zugewandte und voneinander beabstandete Elektrodenseiten aufweisen.

Bei dieser Bedieneinheit ist erfindungsgemäß vorgesehen,
- dass die erste Elektrode an dem Bedienelement angeordnet ist,
- dass die zweite Elektrode unbeweglich angeordnet ist, und
- dass sich die beiden Elektroden bezüglich einer ihrer beiden die Elektrodenseiten aufspannenden Dimensionen parallel zur Richtung der bei manueller Überführung des Bedienelements in die Auswähl- und/oder Auslöseposition erfolgender Relativbewegung der beiden Elektroden erstrecken,
- wobei die Größe der während der Relativbewegung der beiden Elektroden gegebenen Überlappungsflächen der gegenüberliegenden Elektrodenseiten im Wesentlichen gleichbleibt.

Nach der Erfindung wird eine kapazitive Annäherungssensorik für ein Bedienelement einer (z. B. Fahrzeugkomponenten-)Bedieneinheit vorgeschlagen, bei der eine im bzw. am Bedienelement angeordnete und damit zusammen mit dem Bedienelement bewegbare erste Elektrode und eine in oder an der Bedieneinheit und damit feststehend angeordnete zweite Elektrode derart relativ zueinander positioniert sind, dass sich ihr Abstand und die Größe der für die kapazitive Kopplung beider Elektroden verantwortlichen in der Projektion betrachtet gegenüberliegenden bzw. überlappenden, hintereinanderliegenden Flächenbereiche beider Elektroden jeweils im Wesentlichen nicht verändern. Damit bleibt die Kapazität bei Betätigung und Bewegung des Bedienelements im Wesentlichen unverändert, so dass der Störabstand, mit dem die Auswerteeinheit eine Berührung/Annäherung des Bedienelements von einer Nicht-Berührung bzw. Nicht-Annäherung unterscheiden kann, während der Betätigung des Bedienelements im Wesentlichen gleich ist.

Gemäß einer bevorzugten Ausgestaltung der Erfindung ist vorgesehen, dass die Elektrodenseite der ersten Elektrode eine parallel zur Relativbewegungsrichtung der beiden Elektroden verlaufende Erstreckung aufweist, die kleiner ist als die parallel zur Relativbewegungsrichtung verlaufende Erstreckung der Elektrodenseite der zweiten Elektrode, und dass die Elektrodenseite der ersten Elektrode während der Relativbewegung beider Elektroden in der Projektion rechtwinklig zur Relativbewegungsrichtung betrachtet innerhalb der Elektrodenseite der zweiten Elektrode verbleibt. Hierbei liegt also die bewegbare erste Elektrode über die gesamte Bewegung des Bedienelements von der "Erst"-Berührung bis zur Auswahl der Bedienfunktion und - optional - bis zur Auslösung der Bedienfunktion durch eine entsprechende weitere Betätigung des Bedienelements stets einem (anderen) Flächenbereich der feststehenden zweiten Elektrode gegenüber, ohne dass sich der Grad der kapazitiven Kopplung beider Elektroden verändert.

Das erfindungsgemäße Konzept findet insbesondere Anwendung bei Druck- und Kipp- bzw. Wipptasten. Bei diesen Tasten ist deren Bewegung beim Berühren der Taste im Wesentlichen beschränkt auf ein Niederdrücken der Taste zur Aktivierung der bzw. einer Bedienfunktion durch Auslösen einer Schaltfunktion mittels eines beim Niederdrücken betätigbaren Schalters. Im Falle eines zusätzlich auch drehbaren Bedienelements oder bei einem verschiebbaren Bedienelement wird mit dem erfindungsgemäßen Konzept ferner verhindert, dass sich beim Verdrehen oder Verschieben des Bedienelements zum z. B. Auswählen eines Menüunterpunktes oder einer Eingabe auf einer graphischen Bedienoberfläche oder der Größe eines Einstellparameters (z. B. vor dessen Betätigung) eine (wesentliche) Kapazitätsänderung in der Annäherungssensorik ergibt. Bei diesen beiden zuletzt genannten Beispielen ist das Bedienelement als Drehknopf- oder als Schiebeelement ausgebildet, das manuell aus einer aktuell eingenommenen Dreh- bzw. Verschiebeposition in eine Auswählposition bewegbar und aus dieser weiter in die Auslöseposition überführbar ist.

In weiterer vorteilhafter Ausgestaltung der Erfindung kann vorgesehen sein, dass das Bedienelement eine Berührungsfläche zur manuellen Berührung durch eine Person aufweist und dass die Berührungsfläche elektrisch leitend und mit der ersten Elektrode elektrisch verbunden ist.

Die Erfindung wird nachfolgend anhand mehrerer Ausführungsbeispiele sowie unter Bezugnahme auf die Zeichnung näher erläutert. Im Einzelnen zeigen dabei:
- Fig. 1: schematisch den Aufbau einer Kipptaste mit einer anders als nach der Erfindung ausgestalteter kapazitive Annäherungssensorik,
- Fig. 2: eine Darstellung eines Teils der Annäherungssensorik der Kipp-Taste der Fig. 1,
- Fig. 3: schematisch eine konstruktive Veränderung der Kipptaste der Fig. 1 mit erfindungsgemäß aufgebauten Elektroden der Annäherungssensorik,
- Fig. 4: schematisch ein weiteres Ausführungsbeispiel der Erfindung mit Drehknopf als Bedienelement und
- Fig. 5: schematisch ein letztes Ausführungsbeispiel der Erfindung mit einem verschiebbar beweglichen Bedienelement.

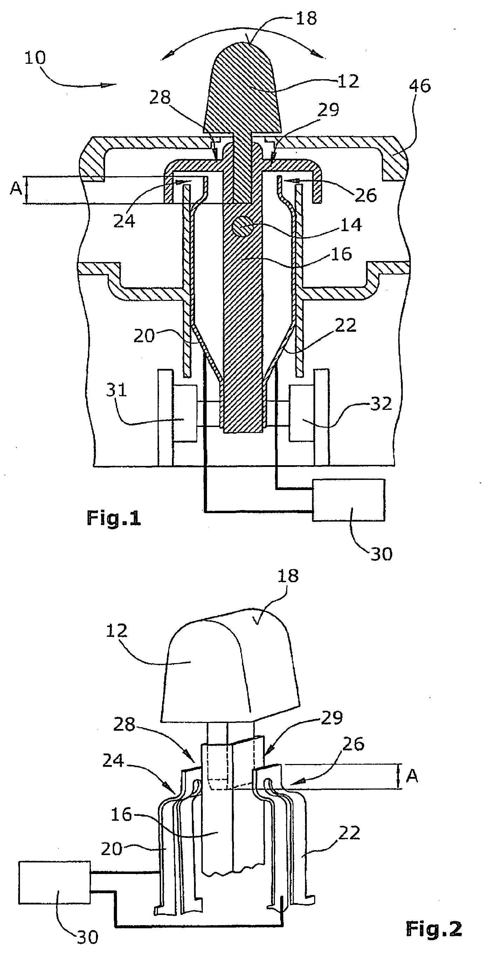

Ausgehend von den Fign. 1 und 2 wird nachfolgend erläutert, welche Ausgestaltung der Elektroden eine unerwünschte Kapazitätsänderung bei Betätigung eines Bedienelements zur Folge hat; daraus kann dann abgeleitet werden, wie die Elektroden der Kapazität einer Annäherungssensorik eines Kipptasten-Bedienelements auszustatten sind, um bei der Betätigung unerwünschten Kapazitätsänderungen nicht ausgesetzt zu sein.

Die Kipptaste 10 weist das eigentliche Bedienelement 12 auf, das mit einem bei 14 drehbar gelagerten Hebel 16 verbunden ist. Das Bedienelement 12 hat z. B. eine verchromte und somit leitfähige Oberfläche 18. Die mechanische Rückstellung des Hebels 16 wird mit den beiden seitlichen Blattfedern 20,22 sichergestellt. Diese Blattfedern 20,22 haben zusätzliche Bereiche 24,26, die nicht mechanisch federn sondern zur kapazitiven Erfassung einer Bedienelement-Berührung genutzt werden. Im Bereich der Überlappung A werden zwei Kondensatoren 28,29 gebildet (siehe auch Fig. 2), die einen Annäherungssensor bilden und deren Kapazitätsänderung durch Berührung elektronisch z. B. in einer Auswerteeinheit 30 ausgewertet wird. Die Schalter zur Auslösung von Bedienfunktionen (z. B. Gebläse anheben oder absenken oder Solltemperaturen größer oder kleiner) sind bei 31,32 gezeigt und wirken mit dem Ende des Hebels 16 zusammen.

Beim ersten Musteraufbau wurde durch die Kippbewegung der Taste der Abstand zwischen Bedienelement-Oberfläche und der Sensorfläche der Blattfedern verändert. Ursache hierfür ist die radiale Anordnung der Sensorflächen. Dies hat große Signalschwankungen der kapazitiven Sensorik zur Folge.

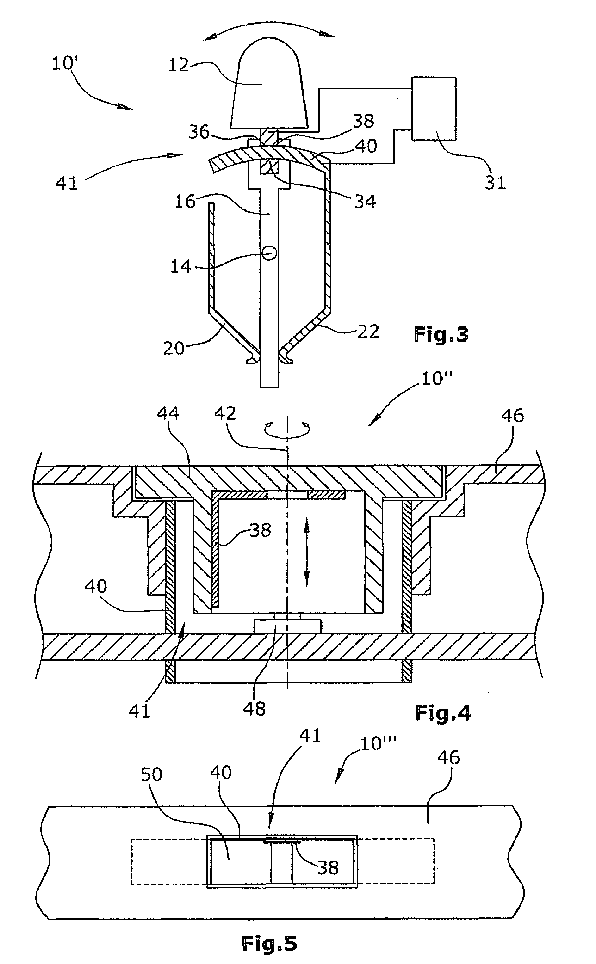

Eine erfindungsgemäße Abwandlung der Kipptaste 10 gemäß Fig. 1 ist schematisch in Fig. 3 gezeigt. Hierbei wird das obige Funktionsprinzip zur kapazitiven Kopplung von metallischer Bedienelementoberfläche zur metallischen Sensorfläche übernommen, jedoch werden bezogen auf die Drehachse 14 der Kipptaste 10' axiale Flächen 34,36 zweier Elektroden 38,40 einer Annäherungssensorik 41 zur Kopplung genutzt, deren Abstand beim Kippen der Kipptaste 10' nicht verändert wird. Außerdem bleiben die sich jeweils gegenüberliegenden kapazitiven Koppelflächen beider Elektroden 38,40 im Wesentlichen gleich groß, wenn die Kipptaste 10' betätigt wird. Durch den erfindungsgemäßen Aufbau der Annäherungssensorik 41 ergibt sich nicht nur der Vorteil, dass der Abstand zwischen den kapazitiv gekoppelten Flächen konstant ist; dieser Abstand kann auch kleiner ausgeführt werden, da kein Bewegungsraum der Sensorflächen vorgesehen werden muss. Diese Abstandsreduzierung ermöglicht deutlich stärkere Sensorsignale.

Fig. 4 zeigt (teilweise) eine Bedieneinheit 10" mit Drehknopf und erfindungsgemäß konstruierter Annäherungssensorik gemäß einem weiteren Ausführungsbeispiel der Erfindung. Die Bedieneinheit 10" gemäß Fig. 4 weist einen um die Achse 42 drehbaren Drehknopf 44 auf, der von einer Blende oder Abdeckung 46 der Bedieneinheit umgeben sein kann. Eine erste Elektrode 38 ist an dem Drehknopf 44 angeordnet und ist kapazitiv mit einer feststehenden zweiten Elektrode 40 gekoppelt. Beide Elektroden erstrecken sich zweckmäßigerweise in Umfangsrichtung über 360° und sind damit zylindermantelähnlich sowie koaxial zueinander angeordnet. Eine der beiden Elektroden 38,40 der Annäherungssensorik 41 könnte sich auch lediglich über einen Teilabschnitt in Umfangsrichtung erstrecken. In beiden Fällen bleibt der Abstand der beiden Elektroden 38,40 beim Verdrehen des Drehknopfes 44 sowie die Größe der sich gegenüberliegenden kapazitiv gekoppelten Flächen der Elektroden 38,40 gleich. Dies gilt auch dann, wenn der Drehknopf 44 z. B. durch Bestätigung einer Eingabe einer durch vorheriges Drehen des Drehknopfes 44 ausgewählten Funktion oder vorgegebenen Parameter niedergedrückt wird, um mittels eines Schalters 48 eine Schaltfunktion auszulösen.

In Fig. 5 ist die erfindungsgemäße Anordnung der beiden Elektroden 38,40 einer Annäherungssensorik 41 bei einem linear verschiebbaren Bedienelement 50 einer weiteren Bedieneinheit 10"' realisiert. Auch hier gilt über den gesamten Verschiebeweg des Bedienelements 50, dass der Abstand der Elektroden 38,40 und die Größe ihrer kapazitiv gekoppelten Flächen jeweils gleich bleibt.

### BEZUGSZEICHENLISTE

- 10: Kipptaste
- 10': alternative Kipptaste
- 10": Bedieneinheit
- 10''': Bedieneinheit
- 12: Bedienelement
- 14: Drehachse
- 16: Hebel
- 18: Berührungsfläche
- 20: Blattfeder
- 22: Blattfeder
- 24: Bereich der Blattfeder
- 26: Bereich der Blattfeder
- 28: Kondensator
- 29: Kondensator
- 30: Auswerteeinheit
- 31: Schalter
- 32: Schalter
- 34: Fläche der ersten Elektrode
- 36: Fläche der zweiten Elektrode
- 38: erste Elektrode
- 40: zweite Elektrode
- 41: Annäherungssensorik
- 42: Achse
- 44: Drehknopf (Drehbedienelement)
- 46: Abdeckung
- 48: Schalter
- 50: Schiebebedienelement

## Patentansprüche

1. Bedieneinheit, insbesondere für eine Fahrzeugkomponente, mit
- einem manuell betätigbaren Bedienelement (12) zum Auswählen und optional zum Aktivieren einer Bedienfunktion,
- wobei das Bedienelement (12) manuell in eine Auswähl- und/oder Auslöseposition zum Auswählen und optional zum Aktivieren einer Bedienfunktion überführbar ist, und
- einem kapazitiven Berührungssensor (41) zur Erkennung einer manuellen Berührung des Bedienelements (12) und optional einer Annäherung an das Bedienelement (12) durch eine Hand,
- wobei der Berührungssensor (41) eine erste und eine zweite Elektrode (38,40) aufweist, die im Wesentlichen einander zugewandte und voneinander beabstandete Elektrodenseiten aufweisen,
**dadurch gekennzeichnet,**
- **dass** die erste Elektrode (38) an dem Bedienelement (12) angeordnet ist,
- **dass** die zweite Elektrode (40) unbeweglich angeordnet ist, und
- **dass** sich die beiden Elektroden (38,40) bezüglich einer ihrer beiden die Elektrodenseiten aufspannenden Dimensionen parallel zur Richtung der bei manueller Überführung des Bedienelements (12) in die Auswähl- und/oder Auslöseposition erfolgender Relativbewegung der beiden Elektroden (38,40) erstrecken,
- wobei die Größe der während der Relativbewegung der beiden Elektroden (38,40) gegebenen Überlappungsflächen (34,36) der gegenüberliegenden Elektrodenseiten im Wesentlichen gleichbleibt.

2. Bedieneinheit nach Anspruch 1, **dadurch gekennzeichnet, dass** die Elektrodenseite der ersten Elektrode (38) eine parallel zur Relativbewegungsrichtung der beiden Elektroden (38,40) verlaufende Erstreckung aufweist, die kleiner ist als die parallel zur Relativbewegungsrichtung verlaufende Erstreckung der Elektrodenseite der zweiten Elektrode (40), und dass die Elektrodenseite der ersten Elektrode (38) während der Relativbewegung beider Elektroden (38,40) in der Projektion rechtwinklig zur Relativbewegungsrichtung betrachtet innerhalb der Elektrodenseite der zweiten Elektrode (40) verbleibt.

3. Bedieneinheit nach Anspruch 1 oder 2, **dadurch gekennzeichnet, dass** das Bedienelement (12) eine niederdrückbare Taste oder eine Kipptaste ist, die in einer Richtung oder in zwei zueinander entgegengesetzten Richtungen kippbar ist.

4. Bedieneinheit nach Anspruch 1 oder 2, **dadurch gekennzeichnet, dass** das Bedienelement als Drehknopf- oder als Schiebeelement (44,50) ausgebildet ist, das manuell aus einer aktuell eingenommenen Dreh- bzw. Verschiebeposition in eine Auswählposition bewegbar und aus dieser weiter in die Auslöseposition überführbar ist.

5. Bedieneinheit nach einem der Ansprüche 1 bis 4, **dadurch gekennzeichnet, dass** das Bedienelement (12) eine Berührungsfläche (18) zur manuellen Berührung durch eine Person aufweist und dass die Berührungsfläche elektrisch leitend und mit der ersten Elektrode (38) elektrisch verbunden ist.

6. Bedieneinheit nach einem der Ansprüche 1 bis 4, **dadurch gekennzeichnet, dass** das Bedienelement (12) eine Berührungsfläche zur manuellen Berührung durch eine Person aufweist und dass die Berührungsfläche mit der ersten Elektrode (38) nicht leitend, jedoch kapazitiv gekoppelt ist.

## Claims

1. A control unit, in particular for a vehicle component, comprising
- a manually actuable control element (12) for selecting and optionally for activating a control function,
- wherein the control element (12) can be moved manually into a selection and/or trigger position for selecting and optionally for activating a control function, and
- a capacitive tactile sensor (41) for detecting manual touching contact with the control element (12) and optionally for detecting the event of a hand approaching the control element (12),
- wherein the tactile sensor (41) has a first and a second electrode (38, 40), which have electrode sides which substantially face one another and are spaced apart from one another,
**characterized in that**
- the first electrode (38) is arranged on the control element (12),
- the second electrode (40) is arranged immovably, and
- the two electrodes (38, 40) extend with respect to one of the two dimensions thereof spanning the electrode sides parallel to the direction of the relative movement of the two electrodes (38, 40), said relative movement being performed as the control element (12) is moved manually into the selection and/or trigger position,
- wherein the size of the overlapping areas (34, 36) of the opposing electrode sides, existing during the relative movement of the two electrodes (38, 40), remains substantially the same.

2. The control unit of claim 1, **characterized in that** the electrode side of the first electrode (38) has a dimension parallel to the direction of relative movement of the two electrodes (38, 40) that is smaller than the dimension of the electrode side of the second electrode (40) parallel to the direction of relative movement, and that, during the relative movement of the two electrodes (38, 40), the electrode side of the first electrode (38) remains inside the electrode side of the second electrode (40), when seen in projection at right angles to the direction of relative movement.

3. The control unit of claim 1 or 2, **characterized in that** the control element (12) is a depressible key or a toggle switch adapted to be toggled in one or in two mutually opposite directions.

4. The control unit of claim 1 or 2, **characterized in that** the control element is designed as a control knob element or a slide element (44, 50) adapted to be moved manually from a currently assumed rotary or sliding position to a selection position and from there onward to the trigger position.

5. The control unit of one of claims 1 to 4, **characterized in that** the control element (12) comprises a contact surface (18) for manual contact by a person, and that the contact surface is electrically conductive and is electrically connected with the first electrode (38).

6. The control unit of one of claims 1 to 4, **characterized in that** the control element (12) has a contact surface for manual contact by a person, and that the contact surface is coupled with the first electrode (38) not conductively, but capacitively.

## Revendications

1. Unité de commande, en particulier pour un composant de véhicule, comprenant :
- un élément de commande (12) pouvant être actionné manuellement pour sélectionner et, éventuellement, activer une fonction de commande,
- l'élément de commande (12) pouvant être amené manuellement dans une position de sélection et/ou de déclenchement pour sélectionner et, éventuellement, activer une fonction de commande, et
- un capteur tactile capacitif (41) pour détecter un contact manuel de l'élément de commande (12) et, éventuellement, l'approche d'une main sur l'élément de commande (12),
- le capteur tactile (41) comportant une première et une seconde électrodes (38, 40) qui présentent des côtés d'électrode sensiblement orientés l'un vers l'autre et distants l'un de l'autre,
**caractérisée**
- **en ce que** la première électrode (38) est disposée sur l'élément de commande (12),
- **en ce que** la seconde électrode (40) est disposée de manière fixe, et
- **en ce que** les deux électrodes (38, 40), relativement à l'une de leurs deux dimensions couvrant les côtés d'électrode, s'étendent parallèlement à la direction du mouvement relatif des deux électrodes (38, 40) opéré lors du passage manuel de l'élément de commande (12) en position de sélection et/ou de déclenchement,
- la grandeur des surfaces de chevauchement (34, 36) des côtés d'électrode opposés, générées lors du mouvement relatif des deux électrodes (38, 40), restant sensiblement constante.

2. Unité de commande selon la revendication 1, **caractérisée en ce que** le côté d'électrode de la première électrode (38) présente une étendue parallèle à la direction de mouvement relatif des deux électrodes (38, 40) qui est plus petite que l'étendue du côté d'électrode de la seconde électrode (40) parallèle à la direction de mouvement relatif, et **en ce que** le côté d'électrode de la première électrode (38), pendant le mouvement relatif des deux électrodes (38, 40) et vu en projection perpendiculaire à la direction de mouvement relatif, reste à l'intérieur du côté d'électrode de la seconde électrode (40).

3. Unité de commande selon la revendication 1 ou 2, **caractérisée en ce que** l'élément de commande (12) est une touche pouvant être enfoncée ou un bouton à bascule pouvant pivoter dans une direction ou dans deux directions opposées.

4. Unité de commande selon la revendication 1 ou 2, **caractérisée en ce que** l'élément de commande est conçu sous forme d'élément de type bouton rotatif ou élément coulissant (44, 50) qui est déplaçable manuellement d'une position de rotation ou de coulissement effectivement prise dans une position de sélection, et transférable ensuite de cette position dans la position de déclenchement.

5. Unité de commande selon l'une des revendications 1 à 4, **caractérisée en ce que** l'élément de commande (12) présente une surface de contact (18) pour contact manuel par une personne et **en ce que** la surface de contact est électriquement conductrice et reliée électriquement à la première électrode (38).

6. Unité de commande selon l'une des revendications 1 à 4, **caractérisée en ce que** l'élément de commande (12) présente une surface de contact pour contact manuel par une personne et **en ce que** la surface de contact est couplée à la première électrode (38) non pas de manière conductrice mais de manière capacitive.
